# FASCICULE DE BREVET EUROPEEN

(11) **EP 3 574 521 B1**
(45) Date de publication et mention de la délivrance du brevet: **09.03.2022**
(21) Numéro de dépôt: 18703075.4
(22) Date de dépôt: 25.01.2018
(51) Int. Cl.: H01L 21/60, G06K 19/077, D02G 3/44

(54) **PROCÉDÉ D'INSERTION D'UN FIL DANS UNE RAINURE D'UNE PUCE DE SEMI-CONDUCTEUR, ET ÉQUIPEMENT POUR LA MISE EN OEUVRE D'UN TEL PROCÉDÉ**
VERFAHREN ZUM EINBRINGEN EINES DRAHTS IN EINE RILLE EINES HALBLEITERCHIPS UND GERÄT ZUR DURCHFÜHRUNG SOLCH EINES VERFAHRENS
METHOD FOR INSERTING A WIRE INTO A GROOVE OF A SEMICONDUCTOR CHIP, AND PIECE OF EQUIPMENT FOR IMPLEMENTING SUCH A METHOD

(30) Priorité: 30.01.2017 FR 1750728
(43) Date de publication de la demande: 04.12.2019
(73) Titulaire: PRIMO1D, 38040 Grenoble Cedex 9 (FR)
(72) Inventeur: ARENE, Emmanuel, 38330 Biviers (FR); LETHIECQ, Robin, 38000 Grenoble (FR); NGUYEN, Pavina, 38000 Grenoble (FR); MACKANIC, Christopher, 38420 Le Versoud (FR)
(74) Mandataire: IP Trust
(86) Numéro de dépôt international: PCT/FR2018/050166
(87) Numéro de publication internationale: WO 2018/138437

(56) Documents cités:
- EP-A1- 2 390 194
- EP-A2- 2 339 618
- EP-A2- 2 429 006
- WO-A1-2009/112644
- WO-A1-2014/041107

## Description

### DOMAINE DE L'INVENTION

La présente invention concerne un procédé d'insertion d'un fil dans une rainure d'une puce de semi-conducteur en vue de leur assemblage. Elle concerne également un équipement mettant en œuvre ce procédé d'insertion. Elle trouve un exemple d'application dans le domaine de l'étiquetage électronique RFID (« Radiofrequency Identification » selon la terminologie anglo-saxonne) pour associer directement une antenne à une puce d'émission-réception et fournir un dispositif radiofréquence particulièrement petit en taille et simple de fabrication. Ce dispositif peut être intégré dans un fil textile et ce fil lui-même intégré à une grande variété d'objets pour leurs identifications, leurs suivis, et leurs administrations.

### ARRIERE PLAN TECHNOLOGIQUE DE L'INVENTION

On connaît par exemple des documents US8471713, US8093617, US8723312, US2015318409, US8782880, US8814054 ou US 2015230336 la technologie d'assemblage d'un fil et d'une puce désignée par la dénomination commerciale E-THREAD^{™}.

Selon cette technologie, la puce est munie d'une rainure longitudinale et on insère une section longitudinale du fil dans cette rainure. L'assemblage peut être obtenu par encastrement du fil dans la rainure, les dimensions du fil et de la rainure étant alors suffisamment ajustées pour solidariser mécaniquement les deux éléments l'un à l'autre. Comme cela est divulgué par les documents WO2009112644 ou WO2014041107, la rainure peut dans certains cas être muni d'un plot permettant, par pincement, de maintenir le fil dans la rainure. Additionnellement ou alternativement, l'assemblage peut être obtenu ou renforcé par l'ajout d'une matière adhésive entre le fil et la puce, par soudure ou brasage du fil et de la puce.

Dans le document US8471773, le fil est électriquement conducteur et la puce de semi-conducteur contient un circuit d'émission réception. L'assemblage du fil et de la puce permet de mettre en contact le fil et une borne d'entrée-sortie du circuit d'émission réception pour former un dispositif d'émission réception fonctionnel. Le fil constitue une antenne de ce dispositif.

L'insertion du fil dans la rainure de la puce est une opération particulièrement délicate, notamment dans un contexte industriel où il est nécessaire de pouvoir tenir une cadence de fabrication importante.

Le document US8782880 et le membre de la même famille de brevets EP2390194 divulguent un équipement d'insertion permettant de tenir une telle cadence. Des fils de grandes dimensions sont fournis dans l'équipement sous la forme de bobines et les puces stockées dans un réservoir. Deux fils sont dévidés des bobines pour être amenés, parallèles l'un à l'autre, au niveau d'une zone de pincement de l'équipement. Celui-ci est également configuré pour amener successivement des puces issues du réservoir au niveau de cette zone de pincement, entre les deux fils, et encastrer une section longitudinale de chaque fil dans une rainure longitudinale de la puce. Alternativement, ce document prévoit de souder le fil et un plot métallique disposé dans la rainure l'un à l'autre pour solidariser la puce et le fil, à la sortie de l'équipement d'insertion. On forme de la sorte une chaîne composée d'une pluralité de puces reliées par des fils de grandes dimensions. La chaîne de puces peut être enroulée sur un support pour former une bobine de stockage. Des segments de cette chaîne peuvent être prélevés de la bobine de stockage en découpant les fils suivant un motif désiré de découpe.

La technologie d'insertion prévue dans cet équipement nécessite l'application d'efforts relativement importants sur les fils pour les encastrer dans les rainures. Cette insertion « en force » du fil dans la rainure peut conduire à le fragiliser ou provoquer sa rupture au cours ou après son insertion. De plus, cette technologie d'insertion est particulièrement sensible au bon ajustement des dimensions de la rainure et du fil. Un mauvais ajustement peut conduire à un assemblage insuffisamment robuste, ou au contraire, nécessiter un effort excessif pouvant conduire à la rupture du fil ou à son endommagement.

Il serait avantageux de pouvoir disposer d'une technique d'insertion qui ne nécessite pas l'application d'efforts aussi importants que ceux de l'état de la technique. Il serait également avantageux de pouvoir réaliser l'insertion et l'assemblage du fil et de la puce au cours d'une même étape, sans effort excessif.

### BREVE DESCRIPTION DE L'INVENTION

En vue de la réalisation de l'un au moins de ces buts, l'objet de l'invention propose, selon un premier aspect, un procédé d'insertion d'un fil dans une rainure longitudinale d'une puce de semi-conducteur en vue de leurs assemblages, Z selon le revendication 1.

Selon d'autres caractéristiques avantageuses et non limitatives de l'invention, prises seules ou selon toute combinaison techniquement réalisable :
- le procédé comprend, à l'issue de l'étape d'insertion, la solidification du matériau de liaison pour assembler le fil et la puce ;
- le fil est maintenu en tension en regard de la rainure et l'étape de mise en place consiste à plaquer le fil contre le plot ;
- le plot est porté à la température de traitement par induction en exposant la zone à un flux d'air chaud ou à un flux lumineux ;
- le procédé comprend, avant ou pendant l'étape de mise en place, une étape de préparation de la section longitudinale de fil destinée à être insérée dans la rainure ;
- l'étape de préparation comprend le dépôt d'une couche d'enrobage sur la section longitudinale du fil ;
- l'étape de préparation comprend une étape de nettoyage et/ou de désoxydation de la section longitudinale du fil ;
- l'étape d'insertion est suivie d'une étape de renforcement comprenant la dispense d'un adhésif dans la rainure et sur la section longitudinale du fil exposée dans la rainure ;
- l'étape d'insertion est suivie d'une étape d'encapsulation de la puce et/ou des fils ;
- le fil est électriquement conducteur ;
- le procédé comprend la répétition des étapes de mise en place et d'insertion de manière à insérer une pluralité de puces sur le fil et former une chaîne (16, 21).

Selon un autre aspect, l'invention propose également un équipement d'insertion d'un fil à au moins une puce, la puce présentant une rainure pour recevoir une section longitudinale du fil et la rainure contenant un plot constitué d'un matériau de liaison présentant une température de fusion déterminée, selon la revendication 12.

Selon d'autres caractéristiques avantageuses et non limitatives de l'invention, prises seules ou selon toute combinaison techniquement réalisable :
- les organes de placement sont configurés pour déployer deux fils parallèles entre la première et la seconde extrémité, et dans lequel la position d'insertion est située entre les deux fils ;
- l'équipement d'insertion comporte au moins un organe additionnel disposé dans l'espace de travail, en aval ou en amont de la position d'insertion de la puce ;
- l'organe additionnel et l'organe de mise en place sont positionnés et configurés dans l'espace de travail pour que les traitements réalisés par ces organes puissent être conduits simultanément.

### BREVE DESCRIPTION DES DESSINS

D'autres caractéristiques et avantages de l'invention ressortiront de la description détaillée de l'invention qui va suivre en référence aux figures annexées sur lesquels :
- Les figures 1a et 1b représentent, en perspective et en coupe, une puce compatible avec un procédé d'insertion conforme à l'invention ;
- les figures 2a à 2e représentent les étapes d'un procédé conforme à l'invention ;
- les figures 3a et 3b représentent un équipement configuré pour mettre en œuvre un procédé conforme à l'invention, à deux instants particuliers de son fonctionnement ;
- les figures 4a à 4c représentent un exemple d'application du procédé à la fabrication d'un premier dispositif d'émission réception ;
- les figures 5a à 5c représentent un exemple d'application du procédé de l'invention à la fabrication d'un deuxième dispositif d'émission réception.

### DESCRIPTION DETAILLEE DE L'INVENTION

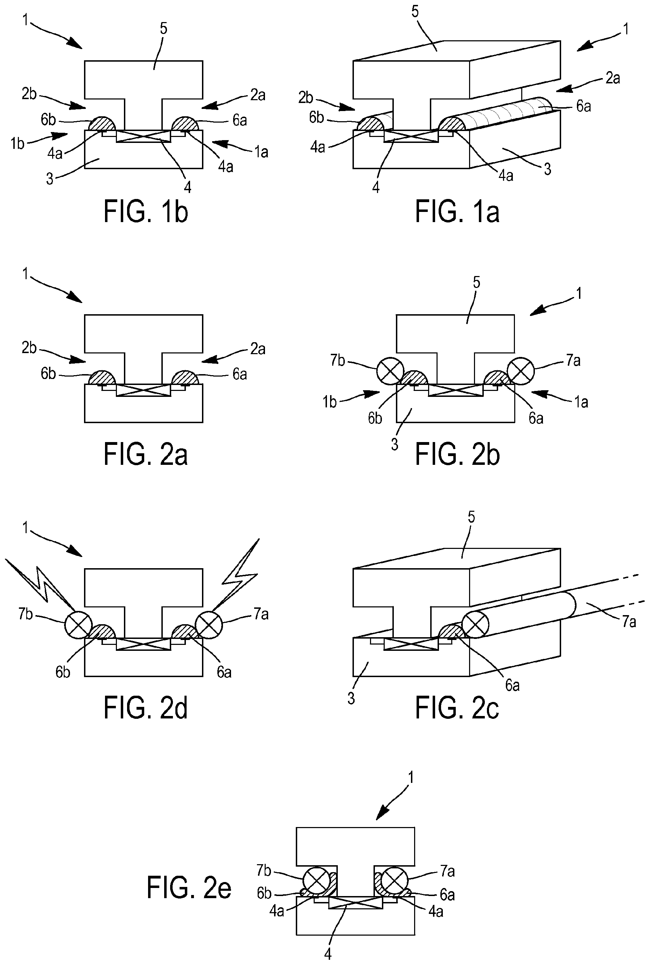

La figure la représente, en perspective, un composant électronique 1, désigné par le terme « puce de semi-conducteur » ou plus simplement « puce » dans la suite de cette description, compatible avec un procédé d'insertion conforme à l'invention. La figure 1b est une vue en coupe d'une telle puce 1.

La puce 1 comporte deux rainures longitudinales 2a, 2b, parallèles entre elles et respectivement formées sur deux faces latérales 1a, 1b de la puce 1, opposées l'une de l'autre. Cette configuration permet de garder toute sa généralité à la description qui va suivre, mais l'invention n'est nullement limitée à ce nombre et à cette disposition de rainures, et la puce 1 peut tout à fait être munie d'une unique ou d'un nombre quelconque de rainures, chacune disposée selon une orientation quelconque sur l'une quelconque des faces de la puce 1, sans sortir du cadre de l'invention. Ces rainures longitudinales 2a, 2b sont prévues pour chacune recevoir et loger une section longitudinale d'un fil (non représenté sur ces figures la et 1b). Pour faciliter l'insertion du fil, chaque rainure 2a, 2b s'étend, sur la face de la puce sur laquelle elle est disposée, d'un coté à l'autre de la puce 1. On désignera, dans la suite de cette description, par « section longitudinale du fil », la portion de fil qui est logée ou est appelée à être logée dans une rainure de la puce, selon sa longueur.

Selon l'invention, les dimensions en hauteur et en profondeur des rainures 2a, 2b sont choisies suffisamment grandes, ou la section transversale des fils choisie suffisamment petite, pour que chaque fil puisse être logé dans une rainure 2a, 2b sans mécaniquement forcer son encastrement. Il est généralement préférable, pour favoriser la solidarisation du fil à la puce 1, que la section longitudinale des fils puisse être entièrement logée dans les rainures, c'est à dire que la portion logée de chaque fil ne déborde pas de la face de la puce sur laquelle la rainure est formée. Lorsque la puce 1 présente une pluralité de rainures 2a, 2b comme c'est le cas sur les figures la et 1b, celles-ci ne sont pas nécessairement de mêmes dimensions. Similairement, les fils qui sont destinés à être logés dans les rainures ne sont pas nécessairement de même nature et ne présentent pas nécessairement des sections transversales de dimensions identiques.

La puce 1 comprend un substrat 3 comportant un circuit fonctionnel 4, tel qu'un circuit d'émission réception, un dispositif de calcul, un capteur, une LED ou tout autre forme de circuit intégré réalisé sur le substrat 3, par exemple à l'aide de techniques connues dans le domaine du semi-conducteur. Le circuit fonctionnel 4 peut être électriquement relié à une ou une pluralité de bornes de connexion 4a, 4b débouchant dans l'une et/ou l'autre des rainures 2a, 2b à l'aide de pistes ou de vias conducteurs formés sur ou dans le substrat 3. On peut alors mettre en contact électrique l'un au moins des fils, lorsqu'il est inséré dans une des rainures 2a, 2b avec le circuit fonctionnel 4. Dans ce cas, le fil assemblé à la puce 1 ne constitue pas un simple support mécanique pour cette puce 1, mais peut contribuer à son fonctionnement, par exemple en formant une antenne, ou en reliant électriquement la puce à une alimentation électrique, ou encore en distribuant un signal à une autre puce qui lui serait également reliée. Dans ce cas, bien entendu, le fil est constitué ou comprend un matériau électriquement conducteur. Si le fil est muni d'une gaine isolante, il peut être nécessaire de dénuder ce fil au niveau de sa section longitudinale appelée à être logée dans la rainure afin de permettre la mise en contact électrique avec une borne de connexion. Mais l'invention n'est nullement limitée à un fil conducteur électrique relié à une borne de connexion disposée dans une rainure de la puce 1. On peut envisager que le fil soit constitué d'un matériau non conducteur formant un support mécanique pour cette puce. Alternativement, la puce peut être munie d'une pluralité de fils disposés dans des rainures, un fil au moins pouvant être un conducteur métallique relié électriquement à la puce 1, un autre fil au moins pouvant être un isolant électrique et ne servant que de support.

Poursuivant la description des figures la et 1b, la puce 1 comprend également un capot 5, présentant une section en forme de T, le pied du T étant assemblé avec une face principale du substrat 3. On constitue de la sorte les deux rainures longitudinales 2a, 2b entre la barre du T du capot 5 et la surface principale d'assemblage du substrat 3. Tout comme le substrat 3, le capot 5 peut également être muni d'un circuit fonctionnel, de bornes de connexion et/ou de pistes ou de vias conducteurs. Ces éléments peuvent être reliés électriquement et fonctionnellement au circuit fonctionnel 4.

D'autres configurations de la puce 1 que celle représentée en figure 1a et 1b sont possibles. Par exemple, la puce 1 peut être formée d'un unique support plan comportant le circuit fonctionnel 4, les rainures longitudinales 2a, 2b étant formées, par exemple par gravure, sur deux faces latérales opposées de ce support, ou sur l'une et/ou l'autre des faces principales de ce support. Selon une autre configuration, la puce 1 peut être formée de deux supports plans de dimensions identiques ou similaires, comportant l'un et/ou l'autre un circuit fonctionnel. Les supports plans sont assemblés chacun aux deux faces opposées d'une entretoise de plus petite dimension, pour définir les deux rainures longitudinales 2a, 2b de la puce 1. L'entretoise peut être constituée d'une pièce solide ou être constituée d'une couche d'adhésif suffisamment rigide.

Quelle que soit la configuration retenue, une puce 1 compatible avec un procédé d'insertion conforme à l'invention comporte au moins une rainure longitudinale 2a, 2b permettant de recevoir et loger une section longitudinale d'un fil.

Selon l'invention également, la rainure 2a, 2b contient au moins un plot 6a, 6b formé d'un matériau de liaison. Dans l'exemple représenté sur les figures 1a, 1b, les plots 6a, 6b sont disposés dans les rainures 2a, 2b sur la face du support 5 formant une des parois des rainures 2a, 2b, et sur toutes leurs longueurs. On pourrait également choisir de disposer les plots 6a, 6b sur une autre des parois constituant les rainures 2a, 2b, par exemple du côté du capot 5. On pourrait également choisir de constituer chaque plot 6a, 6b d'une pluralité de plots élémentaires, distincts les uns des autres, disposés dans une rainure sur une longueur réduite. Quelle que soient la forme, le volume, la disposition occupée par les plots 6a, 6b dans les rainures 2a, 2b ceux-ci présentent une dimension telle, qu'en leur présence il n'est pas possible de parfaitement loger les fils dans les rainures 2a, 2b. Comme cela sera rendu explicite dans la suite de cette description, chaque plot 6a, 6b forme une réserve d'un matériau de liaison qui permettra l'assemblage et la bonne tenue mécanique du fil logé dans chacune des rainures 2a, 2b.

Le matériau constituant chaque plot 6a, 6b est choisi pour que sa température de fusion soit relativement peu élevée. Cette température de fusion est inférieure à la température maximale à laquelle le circuit fonctionnel 4 de la puce 1 peut-être exposé sans être endommagé. Si, par exemple cette température maximale est de 350°C, on choisira le matériau des plots 6a, 6b pour que sa température de fusion soit plus petit que 350°C, par exemple 300°C. Avantageusement, pour des raisons de simplicité du procédé d'insertion dont la description va suivre, ce matériau est choisi pour que sa température de fusion soit comprise entre 80°C et 100°C ou 150°C, ou 250°C. Le matériau constituant chaque plot 6a, 6b peut comprendre une pluralité de composés élémentaires. Il peut par exemple s'agir d'un alliage de métaux, par exemple d'étain, d'argent et de cuivre. On note que la puce 1 est destinée à être manipulée à la pression atmosphérique, et donc que la température de fusion évoquée est déterminée à cette pression. Par ailleurs, il n'est pas nécessaire que tous les plots 6a, 6b ou tous les plots élémentaires soient constitués du même matériau. Avantageusement, notamment lorsqu'un plot 6a, 6b permet de relier électriquement un fil à une borne de connexion de la puce 1, il est formé d'un matériau conducteur électrique. Mais, comme on l'a noté précédemment, cela n'est pas nécessairement le cas.

La puce 1 peut être fabriquée en grande série, en employant des technologies du domaine des circuits intégrés semi-conducteurs, comme cela est enseigné dans les documents cités de l'état de la technique. Les plots 6a, 6b peuvent avantageusement être fabriqués au cours de la fabrication de la puce 1, par exemple en les formant par dépôt sur le substrat 3 avant son assemblage avec le capot 5 ou, plus généralement avant la formation du capot 5. On peut également envisager de former les plots 6a, 6b dans les rainures longitudinales 2a, 2b après la fabrication de la puce 1, par exemple en dispensant le matériau de liaison formant ces plots 6a, 6b sous forme liquide, à une température supérieure à son point de fusion, directement dans les rainures 2a, 2b.

La présente invention met à profit les caractéristiques de la puce 1 pour proposer un procédé d'insertion d'au moins un fil dans au moins une rainure 2a, 2b de la puce 1 particulièrement astucieux, qui ne nécessite pas un encastrement forcé de ce fil, et qui limite donc les efforts appliqués au fil pendant son insertion. Ce procédé est décrit en référence aux figures 2a à 2e.

On note tout d'abord que le fil peut être de nature quelconque dans la mesure où il est suffisamment résistant aux traitements mécaniques et chimiques qui vont être exposés. Avantageusement, le fil est un fil électrique conducteur, par exemple en inox, un alliage à base de cuivre ou en cuivre, et le procédé d'insertion permet de mettre en liaison électrique ce fil avec une borne 4a, 4b du circuit fonctionnel 4 de la puce 1.

La figure 2a représente une puce 1 conforme à la description qui vient d'en être faite.

Au cours d'une étape de mise en place, on dispose une section longitudinale de deux fils 7a, 7b le long de deux rainures 2a, 2b. Le plot 6a, 6b occupe une portion suffisante de la rainure 2a, 2b pour ne pas permettre de loger entièrement le fil dans celle-ci. Au cours de l'étape de mise en place, on exerce des efforts limités sur le fil 7a, 7b pour le plaquer contre le plot 6a, 6b et le mettre en butée forcée contre lui. Les figures 2b et 2c représentent la puce 1 et deux fils 7a, 7b à l'issue de cette étape de mise en place. Les fils 7a, 7b sont en contact avec les plots 6a, 6b, ils peuvent également être en contact avec l'une des arêtes du substrat 3 et/ou du capot 5 définissant les contours des rainures 2a, 2b sur les faces latérales 1a, 1b de la puce 1. Dans le cas où un plot 6a, 6b ne s'étend pas sur toute la longueur d'une rainure 2a, 2b, une portion de la section longitude d'un fil peut-être partiellement logée dans celle-ci.

On rappelle que le diamètre des fils est choisi plus petit que la hauteur des rainures, si bien qu'en l'absence des plots 6a, 6b, les fils peuvent être insérés sans effort particulier d'encastrement et être logés dans les rainures 2a, 2b.

Comme cela est présenté aux figures 2d et 2e, le procédé de l'invention comprend également une étape d'insertion, postérieure à l'étape de mise en place. Au cours de cette étape d'insertion, on expose une zone comprenant au moins en partie les plots 6a, 6b à une température de traitement supérieure à la température de fusion du matériau de liaison les composant, et pendant une durée suffisante pour le faire fondre. Le passage à l'état liquide du matériau de liaison, combiné aux efforts modestes exercés sur les fils 7a, 7b conduit à l'insertion de ces derniers dans les rainures 2a, 2b comme cela est visible sur la figure 2e. Il n'est pas nécessaire que le matériau de liaison des plots 6a, 6b passe dans sa totalité à l'état liquide pour provoquer l'insertion des fils 7a, 7b. Il suffit en effet que seule une portion de matériau se liquéfie pour dégager un passage suffisant pour permettre l'engagement et le logement des fils 7a, 7b dans les rainures 2a, 2b. La zone exposée à la température de traitement comprend avantageusement tous les plots 6a, 6b, mais il est possible que seule une partie de ces plots 6a, 6b soit directement exposé à la température de traitement, la pouvant être provoquée par conduction thermique.

Lorsque la puce 1 présente plusieurs rainures 2a, 2b pour accueillir plusieurs fils 7a, 7b, comme cela est le cas sur l'exemple représenté sur les figures 2a à 2e, l'étape d'insertion peut être réalisée successivement ou simultanément pour chacun des fils. La zone exposée à la température de traitement peut être suffisamment large pour englober au moins en partie tous les plots 6a, 6b. Alternativement, l'étape d'insertion peut comprendre l'exposition de plusieurs zones distinctes, simultanément ou successivement, chacune englobant une partie au moins des plots 6a, 6b.

L'étape d'insertion peut être mis en œuvre avec un organe de chauffage, par exemple un générateur de flux d'air ou d'un autre fluide chauffé, par induction, ou par une irradiation lumineuse telle qu'une irradiation laser ou un rayonnement ultra-violet, conduisant à générer un flux de chaleur définissant la zone chauffée au niveau de la puce 1. Le flux est maintenu suffisamment longtemps et présente une température suffisante, supérieure au point de fusion du matériau de liaison formant le plot 6a, 6b, pour provoquer sa fusion. Bien entendu, le chauffage peut être global, par exemple en plaçant la puce 1 dans une enceinte chauffée, mais cette approche pourrait être un peu plus complexe à mettre en œuvre industriellement.

Comme cela est visible sur la figure 2e, le matériau de liaison constituant les plots 6a, 6b, une fois à l'état liquide, a tendance à s'enrober autour du fil 7a, 7b, et s'écouler sur les parois définissant les rainures 2a, 2b. Une partie du matériau de liaison peut être absorbé par la section longitudinale de fil et contribue à renforcer la tenue mécanique du fil 7a, 7b dans les rainures 2a, 2b.

Lorsque les fils 7a, 7b sont insérés dans les rainures 2a, 2b, le traitement thermique du matériau de liaison peut être interrompu soit en désactivant l'organe de chauffage, soit en déplaçant la puce 1 et/ou l'organe de sorte à extraire la puce 1 de la zone exposée au flux de chaleur. L'interruption du traitement thermique dans la zone restaure une température inférieure à la température de fusion du matériau de liaison, typiquement à la température ambiante, ce qui conduit à lui redonner une constitution solide et à assembler solidairement le fil à la puce. Lorsque le matériau de liaison et les fils sont des conducteurs électriques, il est ainsi possible de relier électriquement les fils 7a, 7b à des bornes 4a, 4b du circuit fonctionnel 4. On note donc que le procédé permet, de manière combinée, d'insérer le fil et de le solidariser à la puce 1 sans nécessité de déployer des efforts importants d'encastrement. Le plot 6a, 6b forme en quelque sorte une réserve d'un matériau d'assemblage, prédisposée dans les rainures.

Avant l'étape de mise en place, ou pendant cette étape, le procédé de l'invention peut prévoir une étape de préparation des fils 7a, 7b. Cette étape peut ainsi comprendre l'enlèvement d'une gaine isolante entourant un cœur conducteur, lorsque les fils 7a, 7b sont ainsi constitués, de manière à pouvoir former un assemblage électriquement conducteur avec la puce 1. Alternativement, ou en complément, on peut prévoir un traitement de nettoyage ou de désoxydation des fils 7a, 7b pour améliorer la formation de ce contact et/ou l'accroche du matériau de liaison des plots 6a, 6b. Dans certaines variantes, l'étape de préparation peut comprendre l'étamage des fils ou, de manière plus générale, leur enrobage à l'aide d'un matériau permettant de favoriser le contact électrique ou l'accroche du matériau de liaison. Ces traitements peuvent être par exemple réalisés par l'intermédiaire de dispositifs de projection ou d'aspersion de fluides liquides ou rendus liquides selon le traitement visé (acide, solution de nettoyage, alliage métallique liquide,).

Le procédé conforme à l'invention peut également comprendre des étapes complémentaires, après que les fils 7a, 7b aient été insérés dans les rainures 2a, 2b, pendant ou après leur assemblage à la puce 1 par solidification du matériau de liaison. Ainsi, le procédé peut prévoir une étape de renforcement de l'assemblage des fils 7a, 7b à la puce 1. Cette étape est plus particulièrement utile lorsque des efforts non équilibrés sont appliqués à une pluralité de fils 7a, 7b conduisant à la formation de contraintes de cisaillement au niveau de leurs assemblages avec la puce 1. L'étape de renforcement peut comprendre la dispense d'un adhésif dans les rainures 2a, 2b et sur au moins une partie de la section longitudinale des fils 7a, 7b exposée dans les rainures. La dispense de l'adhésif peut être complétée par son insolation, par exemple par traitement UV, qui peut être d'une durée très courte, de l'ordre de la seconde ou de quelques secondes, pour rigidifier l'adhésif et promouvoir sa solidarisation aux éléments avec lequel il est en contact.

Le procédé peut également comprendre, comme étape complémentaire, une étape d'encapsulation de la puce 1 dans un matériau suffisamment rigide et étanche, comme de la résine, permettant de la protéger des sollicitations mécaniques ou chimiques dans son application finale. Préférentiellement, cette encapsulation est telle que toutes les faces de la puce 1, et particulièrement là où les faces sur laquelle les rainures 2a, 2b ont été formées, sont bien recouvertes du matériau encapsulant.

Dans certains cas, notamment lorsque la puce 1 est associée à plusieurs fils 7a, 7b conducteurs, il peut être nécessaire d'isoler électriquement les fils 7a, 7b les uns des autres. L'invention peut donc prévoir une étape complémentaire visant à disposer un isolant électrique sur ou entre les fils 7a, 7b. L'isolant peut être constitué d'un matériau liquide disposé sur et entre les fils conducteurs 7a, 7b, voire même sur la puce 1 elle-même, avant d'être rendu solide. Préférentiellement, le matériau isolant électrique n'est pas excessivement rigide de manière à conserver le caractère déformable des fils 7a, 7b, ce qui peut avoir un intérêt particulier selon l'application visée.

Le procédé peut également comprendre comme étape complémentaire, une étape de mise en contact électrique des fils 7a, 7b, de manière à former une boucle. Cette mise en contact peut mettre en œuvre la dispense d'une colle conductrice.

Le procédé peut également comprendre comme étape complémentaire, une étape de découpe d'un ou des fils 7a, 7b. Il peut s'agir de prélever un segment muni d'au moins une puce 1, en vue de son intégration dans un objet. Il peut également s'agir de découper une portion de fil afin de former une antenne dipôle reliée à la puce 1 comme cela est enseigné dans le document US8471773. La découpe d'un ou des fils 7a, 7b peut être réalisé par tous moyens connus en soi, par exemple à l'aide d'un outil mécanique de cisaillement ou par découpage laser.

On peut également prévoir une étape complémentaire de test et/ou de programmation de la puce 1 après qu'elle ait été assemblée aux fils 7a, 7b afin de s'assurer que les étapes précédentes n'ont pas affecté ses fonctionnalités et/ou la rendre entièrement fonctionnelle.

L'invention propose également un équipement 8 d'insertion d'un fil 7a, 7b dans la rainure 2a, 2b d'une puce 1 de semi-conducteur, permettant de mettre en œuvre un procédé conforme à celui qui vient d'être décrit. L'équipement 8 est particulièrement adapté à l'insertion répétée d'un fil dans une pluralité de puces 1, pour former une chaîne de puces 1.

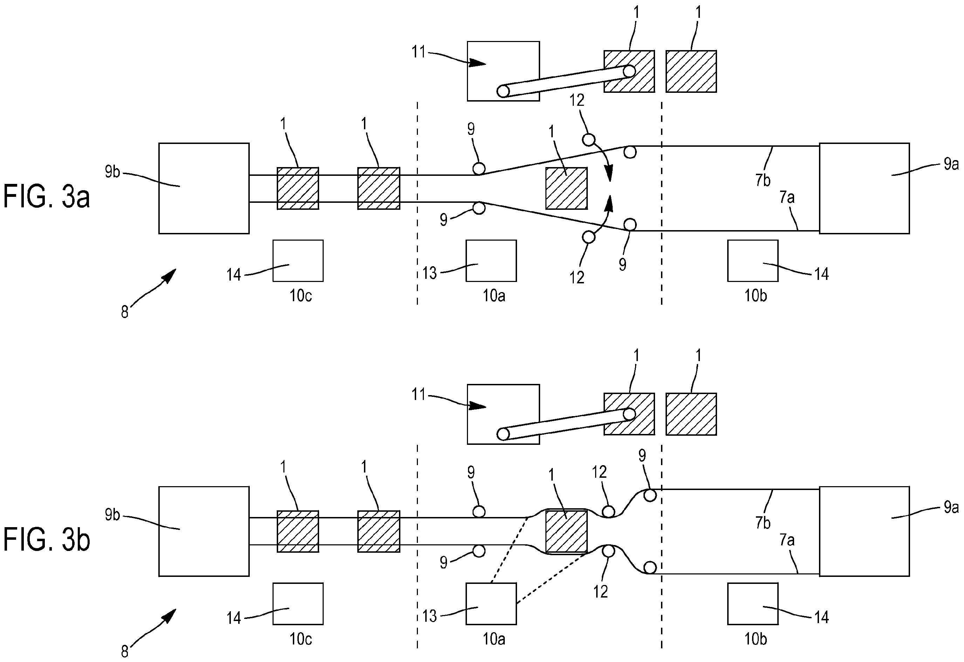

Les figures 3a et 3b représentent un tel équipement à deux instants particuliers de son fonctionnement. L'équipement 8 représenté sur ces figures est configuré pour permettre l'insertion simultanée de deux fils 7a, 7b dans deux rainures 2a, 2b respective d'une puce 1. Mais l'équipement de l'invention n'est nullement limité à cet exemple particulier et les mêmes principes qui vont être exposés peuvent s'appliquer pour l'insertion d'un nombre différent de fils.

L'équipement 8 comprend des organes de placement 9, 9a, 9b pour déployer, sous tension contrôlée, un fil 7a, 7b entre deux extrémités d'un espace de travail. À une première extrémité de cet espace, il peut ainsi être prévu de disposer un organe d'approvisionnement 9a en fil, tel qu'un dévideur, permettant d'extraire les deux fils 7a, 7b de deux bobines d'approvisionnement. Ces fils 7a, 7b se déploient sur toute la longueur de l'espace de travail pour atteindre la seconde extrémité sur laquelle il peut être prévu un organe de stockage 9b tel qu'un enrouleur, permettant de placer sur une bobine de stockage la chaîne de puces qui sera fabriquée par l'équipement 8. Les fils 7a, 7b sont guidés entre les deux extrémités par des organes de guidage 9 tels que des galets ou des rouleaux permettant de positionner et de guider avec précision la position dans l'espace des fils 7a, 7b, notamment au cours de leurs déplacements. Les organes de placement 9a, 9b, 9 peuvent être motorisés pour permettre l'entraînement du fil, assurant au fur et à mesure du traitement réalisé par l'équipement 8, le transfert des fils 7a, 7b de leurs bobines d'approvisionnement vers la bobine de stockage.

Les organes de placement 9, 9a, 9b sont également conçus pour contrôler la tension de chaque fil 7a, 7b pour être comprise entre une tension minimale pour laquelle les fils 7a, 7b ne sont pas tendus et une tension maximale pour laquelle les fils sont susceptibles de se détériorer ou de se rompre. Lorsque l'équipement 8 est conçu pour déployer une pluralité de fils 7a, 7b, comme cela est le cas dans l'exemple représenté, il peut être avantageux de rechercher à maintenir une tension identique entre les deux fils. De même, lorsqu'une pluralité de fils 7a, 7b sont insérés dans au moins une puce 1, il est important que le déplacement des fils 7a, 7b le long de l'espace de travail au cours des traitements réalisés par l'équipement 8 soit réalisé simultanément et avec la même vitesse pour chaque fil 7a, 7b afin d'éviter de générer des efforts de cisaillement sur les puces 1, ce qui pourrait conduire au désassemblage des fils 7a, 7b des rainures 2a, 2b.

Dans l'exemple représenté, les deux fils 7a, 7b sont disposés dans un même plan horizontal afin de pouvoir être inséré dans une puce 1 munie de deux rainures 2a, 2b également disposées dans un même plan. Une autre configuration des rainures 2a, 2b sur la puce 1 pourrait conduire à ajuster différemment la disposition des fils 7a, 7b l'un par rapport à l'autre.

L'espace de travail est composé d'une zone intermédiaire 10a dans laquelle l'étape d'assemblage des fils 7a, 7b et de la puce 1 sont conduits.

En amont de la zone intermédiaire 10a, du côté de la première extrémité et de l'organe d'approvisionnement 9a, les deux fils 7a, 7b sont distants l'un de l'autre d'une distance supérieure à celle séparant les deux fils 7a, 7b lorsqu'ils sont insérés dans les rainures 2a, 2b de la puce 1. Lorsque la distance séparant les rainures 2a, 2b d'une puce 1 est inférieur au millimètre, ce qui est usuel, les deux fils 7a, 7b peuvent être séparés l'un de l'autre, dans la zone amont 10b, de quelques millimètres, comme par exemple 3 mm.

En aval de la zone intermédiaire d'assemblage 10a, du côté de la seconde extrémité de l'équipement 8 et de l'organe de stockage 9b, les fils 7a, 7b sont insérés dans les rainures 2a, 2b et assemblés aux puces 1. La distance séparant les deux fils 7a, 7b est donc imposée par la géométrie la puce 1 et par la profondeur de ses rainures. Cette distance est typiquement inférieure à 1 mm.

Les organes de guidage 9 placés dans la zone intermédiaire 10a, ou directement à proximité de cette zone, permettent de guider l'écartement des fils 7a, 7b entre l'écartement existant dans la zone amont 10b et celle existant dans la zone aval 10c.

L'équipement représenté sur les figures 3a, 3b comprend également un dispositif de manipulation 11, permettant d'extraire une puce 1 d'une zone de stockage de puces pour la placer dans une position d'insertion, située dans la zone intermédiaire 10a entre les fils 7a, 7b. La position d'insertion peut être matérialisée par un plateau sur laquelle la puce 1 peut être placée et maintenue fixement. Lorsqu'un une puce 1 est correctement placée en position d'insertion, les rainures 2a, 2b de la puce sont positionnées en regard et à la même élévation que les fils 7a, 7b et dans le même plan. Le dispositif de manipulation 11 peut correspondre à une machine automatique d'insertion de composants (« Pick and Place » selon la technologie anglo-saxonne) comprenant un bras articulé muni d'une buse d'aspiration permettant de saisir une puce 1 de la zone de stockage et de la placer avec précision dans sa position d'insertion.

L'équipement 8 comprend également un organe de mise en place 12 des fils 7a, 7b. Cet organe 12 placé dans la zone intermédiaire 10a d'insertion peut prendre appui sur les fils 7a, 7b selon deux configurations. Dans une première configuration « ouverte », représentée sur la figure 3a, l'organe de mise en place 12 n'est pas en appui ou pas suffisamment en appui sur les fils 7a, 7b, laissant dégagée un espace entre ces fils 7a, 7b afin de pouvoir y placer une puce 1 en position d'insertion. Dans une seconde configuration de l'organe de mise en place 12, représentée sur la figure 3b, celui-ci est en appui contrôlé pour venir placer les fils 7a, 7b le long des rainures 2a, 2b, plaqués contre les plots 6a, 6b disposés dans ces rainures, et donc en butée forcée contre les plots 6a, 6b.

Selon l'invention, l'équipement 8 comprend également au moins un organe de chauffage 13 disposé dans ou à proximité de la zone intermédiaire 10a, pour porter à une température de traitement une zone comprenant au moins une partie des plots 6a, 6b disposés dans les rainures 2a, 2b, lorsqu'une puce 1 est placée en position d'insertion. Comme on l'a vu dans la description détaillée du procédé de l'invention, l'organe de chauffage 12 permet d'élever la température du matériau de liaison formant les plots 6a, 6b au-dessus de sa température de fusion. L'organe 12 peut comprendre un générateur de flux d'air chaud ou de tout autre fluide gazeux, un générateur de rayonnement lumineux tels qu'un rayonnement UV ou un rayonnement laser, un générateur pour chauffer par induction. L'organe 12 peut comprendre plusieurs générateurs, chaque générateur exposant une zone particulière, localisée par exemple au niveau de chacune des rainures 2a, 2b d'une puce 1 lorsque celle-ci est placée dans la position d'insertion.

L'ensemble des organes qui viennent d'être décrits peuvent être reliés à un dispositif de traitement, non représenté sur les figures, assurant le séquencement des opérations de déplacement des fils 7a, 7b, de mise en place de la puce 1 en position d'insertion, d'actionnement des organes de mise en place 12, et de l'organe de chauffage 13 pour permettre la mise en œuvre, à grande cadence, du procédé d'insertion de l'invention.

Outre les organes disposés dans ou à proximité de la zone intermédiaire 10a d'assemblage qui viennent d'être décrits, l'équipement 8 peut également prévoir, en amont et/ou en aval de cette zone, d'autres organes additionnels 14 pour réaliser les étapes de préparation des fils 7a, 7b, et les étapes complémentaires sur l'ensemble formé de la puce 1 et des fils 7a, 7b. Ces organes additionnels peuvent comprendre des buses de dispense permettant, par exemple, projeter des fluides de nettoyage, de désoxydation, d'étamage ou d'adhésif sur les fils 7a, 7b et/ou dans les rainures 2a, 2b. Les organes additionnels peuvent également comprendre une source laser pour découper un fil ou une source UV pour solidifier un adhésif ou une résine. Il peut également s'agir d'un dispositif mécanique de découpe de fils par cisaillement, ou des moyens de test ou de programmation d'une puce. Préférentiellement, ces organes additionnels 14 permettent de réaliser des traitements des fils 7a, 7b ou de la puce 1 sans entrer en contact avec ces éléments.

Les organes additionnels 14 sont avantageusement répartis, dans l'espace de travail, le long des fils 7a, 7b du côté de la zone amont 10b et dans la zone avale 10c de sorte que les traitements opérés par ces organes et par ceux disposés dans la zone intermédiaire 10a, puissent tous être réalisés simultanément. En d'autres termes, lorsque les fils 7a, 7b sont entraînées par les organes d'approvisionnement 9a, de guidage 9 et de stockage 9b, pour les déplacer d'une portion de longueur correspondant à l'espacement entre deux puces, les organes additionnels sont positionnés en vis-à-vis d'une puce (en aval de la zone intermédiaire insertion) ou en vis-à-vis d'une section longitudinale de fil (en amont de cette zone) qu'ils peuvent traiter. Lorsque l'ensemble des traitements a été réalisé par ces organes, les fils 7a, 7b peuvent être entraînés et déplacés d'une portion de longueur additionnelle.

Dans une variante de mise en œuvre de l'invention, il est possible de procéder à l'entrainement continue des fils 7a, 7b, afin d'augmenter encore la cadence de travail. Dans ce cas, la puce 1 peut être positionnée sur un plateau se déplaçant selon la direction d'entrainement des fils et à une vitesse identique de manière à rendre la puce 1 sensiblement immobile vis à vis des fils 7a, 7b, et permettre leurs insertions dans les rainures 2a, 2b et leurs assemblage.

### Premier exemple

Le procédé et l'équipement 8 qui viennent d'être décrits peuvent être employés pour réaliser un dispositif d'émission réception 15 et une chaîne de tels dispositifs, tel que décrit dans le document US8471773.

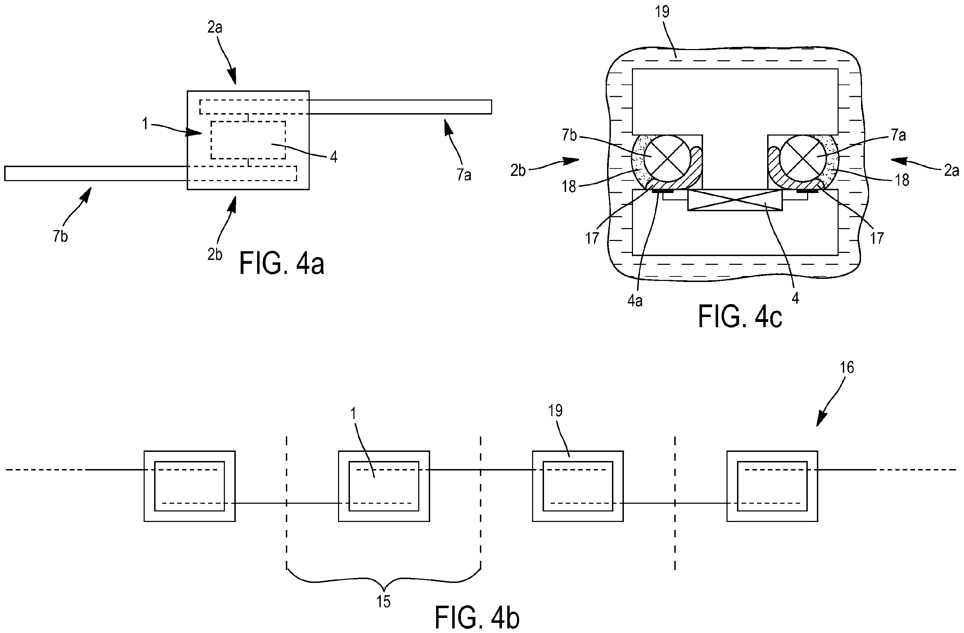

Un tel dispositif 15 est formé d'une puce 1 conforme à celle représentée sur la figure la, comprenant deux rainures longitudinales 2a, 2b disposées sur des faces opposées l'une à l'autre de la puce 1. Deux fils conducteurs 7a, 7b sont placés dans les rainures 2a, 2b. Ces fils s'étendent chacun d'un côté de la puce 1 pour former une antenne en forme de dipôle. Les fils 7a, 7b sont électriquement reliés à des bornes 4a, 4b d'un circuit d'émission réception 4, disposé par exemple dans le substrat 3 de la puce 1. La figure 4a représente schématiquement un tel dispositif d'émission réception 15.

Pour des raisons de résistance mécanique, notamment au pliage, le fil est préférentiellement choisi en inox. Dans certains cas toutefois, on peut préférer d'utiliser des fils en alliage à base de cuivre ou en cuivre.

Pour fabriquer un tel dispositif d'émission réception, ou une chaîne de tels dispositifs, on place deux bobines de fil dans les dérouleurs des organes d'approvisionnement 9a, et on déploie ces fils 7a, 7b à travers les organes de guidage 9 jusqu'à les fixer sur la bobine de stockage de l'enrouleur formant l'organe de stockage 9b. Une fois en place, les différents organes de placements sont actionnés afin de placer les fils en tension et dans un même plan afin de préparer l'insertion des fils 7a, 7b dans des puces 1. Des puces 1 d'émissions réception, par exemple des puces RFID, sont disposés au niveau de la zone de stockage de puces, et peuvent être déplacé, successivement au cours des séquences de traitement, en position d'insertion par le dispositif de manipulation 11. À chaque nouvelle séquence de traitement, les organes composant l'équipement 8 réalisent simultanément les opérations suivantes, avant de déplacer le fil d'une longueur déterminée et de répéter à nouveau ces opérations.

Dans la zone amont 10b de l'espace de travail, au niveau d'un organe additionnel 14 :
- nettoyage, et éventuellement étamage d'une section longitudinale des fils 7a, 7b destinée à être logée dans les rainures 2a, 2b d'une puce 1.

Dans la zone intermédiaire 10a, à l'aide des organes disposés dans cette zone :
- prélèvement d'une puce 1 de la zone de stockage et positionnement de cette puce 1 en position d'insertion ;
- insertion des sections longitudinales des fils 7a, 7b qui ont été préalablement préparées au cours d'une séquence précédente ;
- assemblage des fils 7a, 7b dans les rainures 2a, 2b par liquéfaction et solidification du matériau de liaison formant initialement les plots 6a, 6b.

Dans la zone avale 10c, à l'aide d'organes additionnels 14 disposés dans cette zone en regard d'une pluralité de puces 1 assemblées au fils 7a, 7b au cours de séquences précédentes :
- dispense d'un adhésif dans les rainures 2a, 2b et sur les sections longitudinales des fils exposés dans ces rainures et insolation de l'adhésif pour le durcir et renforcer l'assemblage des fils 7a, 7b à la puce 1 ;
- découpe d'un des deux fils 7a, 7b afin de préformer des antennes en forme de dipôle.
- encapsulation de la puce 1 dans un matériau de protection telle qu'une résine rigide, permettant de la protéger mécaniquement et chimiquement
- test fonctionnel de la puce 1, et programmation de la puce 1 pour lui affecter un numéro d'identification unique.

On note que la dispense d'un adhésif dans les rainures 2a, 2b et sur les sections longitudinales des fils peut conduire à former un ménisque d'adhésif entre le fil et un bord de la puce, perpendiculaire au fil. Ce ménisque contribue à rendre l'assemblage de la puce et des fils 7a, 7b particulièrement robuste aux efforts qui pourraient s'appliquer sur les fils et qui tendraient à les désolidariser de la puce.

A l'issue de la fabrication on dispose d'une bobine de stockage comprenant une chaîne 16 de dispositifs d'émission réception 15, comme cela est représenté schématiquement sur la figure 4b. On peut prélever dans cette chaîne 16 des segments formant un dispositif fonctionnel d'émission réception 15 qui peut être intégré à un objet, par exemple en vue de son identification.

Comme cela est représenté sur la figure 4a, chaque dispositif d'émission réception 15 de la chaine 16 comprend une puce 1 présentant deux rainures longitudinales 2a, 2b parallèles l'une à l'autre et disposées sur deux faces opposées de la puce 1. Le dispositif d'émission réception comprend également un circuit fonctionnel 4 d'émission réception, et deux segments de fils 7a, 7b logés dans les rainures 2a, 2b et débordants chacun d'un côté d'une rainure 2a, 2b pour former une antenne en forme de dipôle. Les segments de fils 7a, 7b sont en contact électrique avec des bornes 4a, 4b du circuit fonctionnel 4, disposées dans la rainure, par l'intermédiaire d'un matériau de liaison 17. Les segments de fil sont également maintenus dans les rainures 2a, 2b par de l'adhésif 18 disposé dans ces rainures 2a, 2b et sur le côté exposé des fils 7a, 7b. La puce 1 est également enrobée et encapsulée d'un matériau de protection 19.

### Deuxième exemple

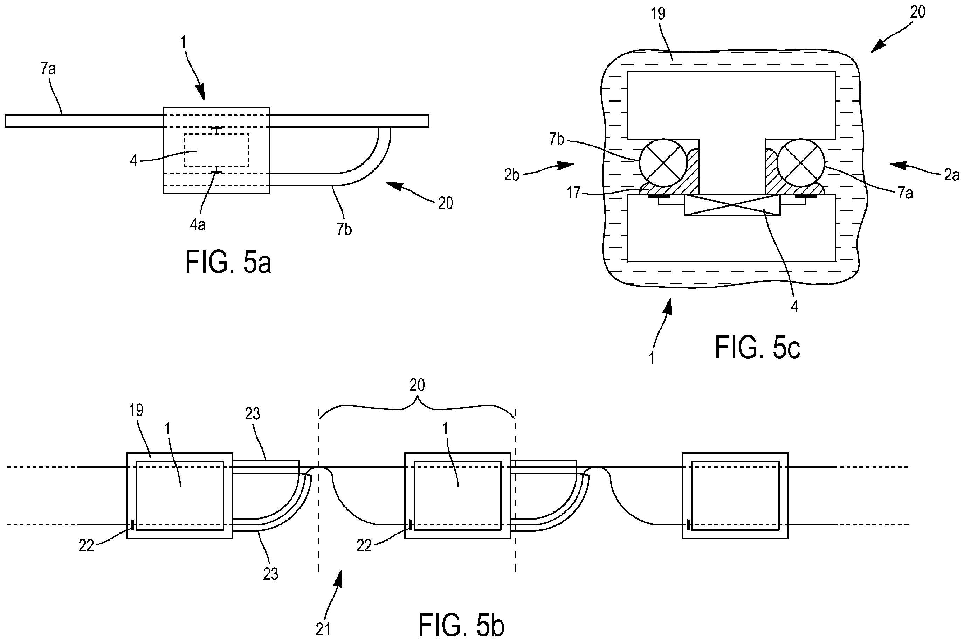

Ce deuxième exemple porte sur un dispositif d'émission réception 20, similaire à celui du premier exemple. Dans ce deuxième exemple toutefois, représenté schématiquement sur la figure 5a, le dispositif d'émission réception 20 présente une antenne comportant une boucle, formée en connectant électriquement l'une des extrémité d'un fil 7b à l'autre fil 7a. Pour fabriquer ce dispositif, on déploie un procédé de fabrication similaire à celui de l'exemple précédent. À chaque nouvelle séquence de traitement, les organes composant l'équipement 8 réalisent simultanément les opérations suivantes, avant de déplacer le fil d'une longueur déterminée et de répéter à nouveau ces opérations.

Dans la zone amont 10b de l'espace de travail, au niveau d'un organe additionnel 14 :
- nettoyage, et éventuellement étamage d'une section longitudinale des fils 7a, 7b destinée à être logée dans les rainures 2a, 2b d'une puce 1.

Dans la zone intermédiaire 10a, à l'aide des organes disposés dans cette zone :
- prélèvement d'une puce 1 de la zone de stockage et positionnement de cette puce 1 en position d'insertion ;
- insertion des sections longitudinales des fils 7a, 7b qui ont été préalablement préparées au cours d'une séquence précédente ;
- assemblage des fils 7a, 7b dans les rainures 2a, 2b par liquéfaction et solidification du matériau de liaison formant initialement les plots 6a, 6b.

Dans la zone avale 10c, à l'aide d'organes additionnels 14 disposés dans cette zone en regard d'une pluralité de puces 1 assemblées au fils 7a, 7b au cours de séquences précédentes :
- dispense d'un matériau électriquement isolant au moins sur les deux fils 7a, 7b disposés d'un côté de la puce pour éviter de les mettre en contact électrique sur une distance déterminée. L'isolant peut également être dispensé sur la puce ;
- Optionnellement, à l'extrémité de la zone isolante qui a été formée ou antérieurement à cette étape d'isolation, mettre en contact électrique les deux fils 7a, 7b, par exemple en les rapprochant l'un de l'autre à l'aide de mors mobiles similaires aux organes de mise en place 12 de la zone intermédiaire et en les soudant l'un à l'autre. Alternativement, on peut prévoir de dispenser une colle conductrice ou tout autre matériau conducteur sur et entre les deux fils 7a, 7b de manière à établir ce contact électrique. On forme de la sorte une boucle. Si cette opération n'est pas réalisée, la formation de la boucle peut être obtenue ultérieurement, après le prélèvement d'un segment de la bobine de stockage, avant ou pendant l'incorporation du dispositif dans un objet ;
- encapsulation de la puce 1 dans un matériau de protection telle qu'une résine rigide, permettant de la protéger mécaniquement et chimiquement. Cette étape d'encapsulation peut être omise lorsque l'on a dispensé préalablement un matériau électriquement isolant sur la puce et les fils ;
- découpe d'un des fils le long de la puce 1, par exemple en formant une entaille 22 au laser dans la couche d'encapsulation assez profonde pour provoquer la rupture locale du fil ;
- test fonctionnel de la puce 1, et programmation de la puce 1 pour lui affecter un numéro d'identification unique.

Dans ce second exemple, il n'est pas nécessaire de procéder à la découpe d'un segment de fil pour former l'antenne. On préserve une chaîne 21 composée de deux fils 7a, 7b sur laquelle sont assemblées les puces 1. On peut prélever de la chaîne de dispositif qui est formé selon la méthode décrite précédemment des segments formant un dispositif fonctionnel d'émission réception qui, similairement à l'exemple précédent, peut être intégré un objet en vue de l'identifier. Cette chaine 21 est représentée schématiquement sur la figure 5b

Comme cela est représenté sur la figure 5c, chaque dispositif d'émission réception 20 comprend une puce 1 présentant deux rainures longitudinales 2a, 2b parallèles l'une à l'autre et disposées sur deux faces opposées de la puce 1. Le dispositif d'émission réception comprend également un circuit fonctionnel 4 d'émission réception, et deux segments de fils 7a, 7b logés dans les rainures 2a, 2b. Il comprend également deux segments de fils 7a, 7b logés dans les rainures 2a, 2b et débordants chacun de parts et d'autres de ces rainures 2a, 2b. Les fils 7a, 7b peuvent être en contact l'un avec l'autre d'un côté de la puce 1 pour former une boucle et la section longitudinale des fils logés dans les rainures 2a, 2b est en contact électrique avec les bornes 4a, 4b d'un circuit fonctionnel 4 disposées dans les rainures 2a, 2b par l'intermédiaire d'un matériau de liaison 17. Les segments de fils constituant la boucle, et éventuellement la puce, peuvent être au moins partiellement enrobée dans un matériau électriquement isolant 23 évitant ainsi de les mettre en contact électrique entre eux. La puce 1 est enrobée et encapsulée d'un matériau protection 19, notamment lorsqu'elle n'a pas été enrobée du matériau isolant. Le ou les matériaux d'encapsulation présentent une entaille 22 ayant servi à découper l'un des fils pour rendre l'antenne fonctionnelle.

Le dispositif d'émission réception 15, 20 du premier et du deuxième exemple peut être inséré dans un fil textile par exemple par guipage, comme cela est enseigné dans le document US8814054. D'une manière plus générale, il peut être inséré dans une matière textile ou plastique, dans un tissus ou une gaine.

Ainsi, le fil textile ou des segments de ce fil comprenant le dispositif d'émission réception, ou d'une manière plus générale la matière textile ou plastique, le tissus ou la gaine dans laquelle le dispositif a été inséré, peut lui-même être intégré dans un objet textile ou non.

Bien entendu l'invention n'est pas limitée au mode de mise en œuvre décrit et on peut y apporter des variantes de réalisation sans sortir du cadre de l'invention tel que défini par les revendications.

## Revendications

1. Procédé d'insertion d'un fil (7a, 7b) dans une rainure longitudinale (2a, 2b) d'une puce de semi-conducteur (1) en vue de leur assemblage, la rainure contenant un plot (6a, 6b) constitué d'un matériau de liaison présentant une température de fusion déterminée, le plot (6a, 6b) occupant une portion suffisante de la rainure (2a, 2b) pour ne pas permettre d'y loger entièrement le fil, le procédé comprenant :
- dans une étape de mise en place, disposer une section longitudinale du fil (7a, 7b) le long de la rainure (2a, 2b), en butée forcée contre le plot (6a, 6b) ;
- dans une étape d'insertion, exposer une zone contenant au moins une partie du plot (6a, 6b) à une température de traitement supérieure à la température de fusion du matériau de liaison et pendant une durée suffisante pour faire fondre au moins en partie le plot (6a, 6b), et provoquer ainsi l'insertion du fil (7a, 7b) dans la rainure (2a, 2b).

2. Procédé d'insertion selon la revendication précédente comprenant, à l'issue de l'étape d'insertion, la solidification du matériau de liaison pour assembler le fil (7a, 7b) et la puce (1).

3. Procédé selon l'une des revendications précédentes dans lequel le fil (7a, 7b) est maintenu en tension en regard de la rainure (2a, 2b) et dans lequel l'étape de mise en place consiste à plaquer le fil (7a, 7b) contre le plot (6a, 6b).

4. Procédé d'insertion selon l'une des revendications précédentes dans lequel le plot (6a, 6b) est porté à la température de traitement en exposant la zone à un flux d'air chaud ou à un flux lumineux ou, lorsqu'il est formé en métal, par induction.

5. Procédé d'insertion selon l'une des revendications précédentes comprenant, avant ou pendant l'étape de mise en place, une étape de préparation de la section longitudinale de fil destinée à être insérée dans la rainure (2a, 2b).

6. Procédé d'insertion selon la revendication précédente dans laquelle l'étape de préparation comprend le dépôt d'une couche d'enrobage sur la section longitudinale du fil.

7. Procédé d'insertion selon l'une des deux revendications précédentes dans lesquelles l'étape de préparation comprend une étape de nettoyage et/ou de désoxydation de la section longitudinale du fil.

8. Procédé d'insertion selon l'une des revendications précédentes dans lequel l'étape d'insertion est suivie d'une étape de renforcement comprenant la dispense d'un adhésif dans la rainure (2a, 2b) et sur la section longitudinale du fil (7a, 7b) exposée dans la rainure (2a, 2b).

9. Procédé d'insertion selon l'une des revendications précédentes dans lequel l'étape d'insertion est suivie d'une étape d'encapsulation de la puce (1) et/ou des fils (7a, 7b).

10. Procédé d'insertion selon l'une des revendications précédentes dans lequel le fil (7a, 7b) est électriquement conducteur.

11. Procédé d'insertion selon une des revendications précédentes comprenant la répétition des étapes de mise en place et d'insertion de manière à insérer une pluralité de puces (1) sur le fil (7a, 7b) et former une chaîne (16, 21).

12. Équipement (8) d'insertion d'un fil (7a, 7b) à au moins une puce (1), la puce présentant une rainure (2a, 2b) pour recevoir une section longitudinale du fil et la rainure (2a, 2b) contenant un plot (6a, 6b) constitué d'un matériau de liaison présentant une température de fusion déterminée, le plot (6a, 6b) occupant une portion suffisante de la rainure (2a, 2b) pour ne pas permettre d'y loger entièrement le fil, l'équipement comportant :
- des organes de placement (9a, 9b, 9) apte à déployer et déplacer une longueur du fil (7a, 7b) entre une première et une seconde extrémité d'un espace de travail ;
- un dispositif de manipulation (11) de la puce (1) apte à disposer la puce dans une position d'insertion dans laquelle la rainure (2a, 2b) est placée en regard du fil (7a, 7b) ;
- un organe de mise en place (12) apte à disposer la section longitudinale du fil (7a, 7b) le long de la rainure (2a, 2b), en butée forcée contre le plot (6a, 6b) ;
- un organe de chauffage (13) apte à porter à une température de traitement excédant la température de fusion déterminée une zone comprenant le plot (6a, 6b) lorsque la puce (1) est placée dans la position d'insertion, provoquant ainsi l'insertion du fil (7a, 7b) dans la rainure (2a, 2b).

13. Equipement d'insertion (8) selon la revendication précédente dans lequel les organes de placement (9a, 9b, 9) sont configurés pour déployer deux fils parallèles entre la première et la seconde extrémité, et dans lequel la position d'insertion est située entre les deux fils.

14. Equipement d'insertion (8) selon l'une des deux revendications précédentes comportant au moins un organe additionnel (14) disposé dans l'espace de travail, en aval ou en amont de la position d'insertion de la puce (1).

15. Equipement d'insertion (8) selon l'une des trois revendications précédentes dans lequel l'organe additionnel (14) et l'organe de mise en place (12) sont positionnés et configurés dans l'espace de travail pour que les traitements réalisés par ces organes puissent être conduits simultanément.

## Patentansprüche

1. Verfahren zum Einbringen eines Drahtes (7a, 7b) in eine Längsnut (2a, 2b) eines Halbleiterchips (1) mit dem Ziel, sie zusammenzufügen, wobei die Nut ein Pad (6a, 6b) enthält, das aus einem Verbindungsmaterial besteht, das eine bestimmte Schmelztemperatur aufweist, wobei das Pad (6a, 6b) einen so großen Teil der Nut (2a, 2b) einnimmt, dass es nicht möglich ist, den Draht vollständig darin aufzunehmen, wobei das Verfahren Folgendes umfasst:
- in einem Anlegeschritt, Anordnen eines Längsabschnitts des Drahtes (7a, 7b) entlang der Nut (2a, 2b), so dass er gegen das Pad (6a, 6b) in Anlage gedrückt wird;
- in einem Einbringschritt, Aussetzen eines Bereichs, der wenigstens einen Teil des Pads (6a, 6b) enthält, einer Behandlungstemperatur, die höher als die Schmelztemperatur des Verbindungsmaterials ist, und über eine Dauer, die ausreicht, um wenigstens einen Teil des Pads (6a, 6b) zu schmelzen, und damit Bewirken des Einbringens des Drahtes (7a, 7b) in die Nut (2a, 2b).

2. Einbringverfahren nach dem vorhergehenden Anspruch, das am Ende des Einbringschritts das Verfestigen des Verbindungsmaterials zum Zusammenfügen des Drahts (7a, 7b) und des Chips (1) umfasst.

3. Verfahren nach einem der vorhergehenden Ansprüche, wobei der Draht (7a, 7b) gegenüber der Nut (2a, 2b) unter Spannung gehalten wird und wobei der Anlegeschritt darin besteht, den Draht (7a, 7b) gegen das Pad (6a, 6b) zu drücken.

4. Einbringverfahren nach einem der vorhergehenden Ansprüche, wobei das Pad (6a, 6b) durch Aussetzen des Bereichs unter einen Heißluftstrom oder einen Lichtstrom oder, wenn er aus Metall ausgebildet ist, durch Induktion auf die Behandlungstemperatur gebracht wird.

5. Einbringverfahren nach einem der vorhergehenden Ansprüche, das vor oder während des Anlegeschritts einen Vorbereitungsschritt für den Längsabschnitt des Drahtes umfasst, der dafür bestimmt ist, in die Nut (2a, 2b) eingebracht zu werden.

6. Einbringverfahren nach dem vorhergehenden Anspruch, wobei der Vorbereitungsschritt das Abscheiden einer Umhüllungsschicht auf dem Längsabschnitt des Drahtes umfasst.

7. Einbringverfahren nach einem der zwei vorhergehenden Ansprüche, wobei der Vorbereitungsschritt einen Reinigungs- und/oder Desoxidationsschritt des Längsabschnitts des Drahtes umfasst.

8. Einbringverfahren nach einem der vorhergehenden Ansprüche, wobei dem Einbringschritt ein Verstärkungsschritt folgt, der das Aufbringen eines Klebstoffs in die Nut (2a, 2b) und auf den in der Nut (2a, 2b) freiliegenden Längsabschnitt des Drahtes (7a, 7b) umfasst.

9. Einbringverfahren nach einem der vorhergehenden Ansprüche, wobei dem Einbringschritt ein Verkapselungsschritt für den Chip (1) und/oder des Drahtes (7a, 7b) folgt.

10. Einbringverfahren nach einem der vorhergehenden Ansprüche, wobei der Draht (7a, 7b) elektrisch leitfähig ist.

11. Einbringverfahren nach einem der vorhergehenden Ansprüche, das das derartige Wiederholen der Anlege- und der Einbringschritte umfasst, dass mehrere Chips (1) auf dem Draht (7a, 7b) aufgebracht werden und eine Kette (16, 21) gebildet wird.

12. Einrichtung (8) zum Einbringen eines Drahtes (7a, 7b) in wenigstens einen Chip (1), wobei der Chip eine Nut (2a, 2b) zum Aufnehmen eines Längsabschnitts des Drahtes aufweist und die Nut (2a, 2b) ein Pad (6a, 6b) enthält, das aus einem Verbindungsmaterial besteht, das eine bestimmte Schmelztemperatur aufweist, wobei das Pad (6a, 6b) einen so großen Teil der Nut (2a, 2b) einnimmt, dass es nicht möglich ist, den Draht vollständig darin aufzunehmen, wobei die Einrichtung Folgendes aufweist:
- Platzierungselemente (9a, 9b, 9), die geeignet sind, eine Länge des Drahtlänge (7a, 7b) zwischen einem ersten und einem zweiten Ende eines Arbeitsraums aufzuziehen und zu bewegen;
- eine Handhabungsvorrichtung (11) für den Chip (1), die geeignet ist, den Chip in einer Einbringposition anzuordnen, in der die Nut (2a, 2b) gegenüber dem Draht (7a, 7b) platziert ist;
- ein Anlegeelement (12), das geeignet ist, den Längsabschnitt des Drahtes (7a, 7b) so entlang der Nut (2a, 2b) anzuordnen, dass er gegen das Pad (6a, 6b) in Anlage gedrückt wird;
- ein Heizelement (13), das geeignet ist, einen Bereich, der das Pad (6a, 6b) umfasst, auf eine Behandlungstemperatur zu bringen, die die bestimmte Schmelztemperatur überschreitet, wenn der Chip (1) in der Einbringposition platziert ist, wobei damit das Einbringen des Drahtes (7a, 7b) in die Nut (2a, 2b) bewirkt wird.

13. Einbringeinrichtung (8) nach dem vorhergehenden Anspruch, wobei die Platzierungselemente (9a, 9b, 9) zum Aufziehen von zwei parallelen Drähten zwischen dem ersten und dem zweiten Ende konfiguriert sind, und wobei sich die Einbringposition zwischen den zwei Drähten befindet.

14. Einbringeinrichtung (8) nach einem der zwei vorhergehenden Ansprüche, die wenigstens ein zusätzliches Element (14) umfasst, das in dem Arbeitsraum der Einbringposition des Chips (1) nachgeschaltet oder vorgeschaltet angeordnet ist.

15. Einbringeinrichtung (8) nach einem der drei vorhergehenden Ansprüche, wobei das zusätzliche Element (14) und das Anlegeelement (12) in dem Arbeitsraum positioniert und konfiguriert sind, damit die durch diese Elemente durchgeführten Behandlungen gleichzeitig vorgenommen werden können.

## Claims

1. Method for inserting a wire (7a, 7b) into a longitudinal groove (2a, 2b) of a semiconductor chip (1) with a view to the assembly thereof, the groove containing a pad (6a, 6b) made of a bonding material having a predetermined melting point, the pad (6a, 6b) occupying a sufficient portion of the groove (2a, 2b) so as to not allow the wire to be fully accommodated therein, the method comprising:
- in an installation step, arranging a longitudinal portion of the wire (7a, 7b) along the groove (2a, 2b), in forced abutment against the pad (6a, 6b);
- in an insertion step, exposing a region containing at least part of the pad (6a, 6b) to a treatment temperature above the melting point of the bonding material and for a period of time which is sufficient to melt at least part of the pad (6a, 6b), and thus cause the wire (7a, 7b) to be inserted into the groove (2a, 2b).

2. Insertion method according to the preceding claim, comprising, at the end of the insertion step, the solidification of the bonding material in order to assemble the wire (7a, 7b) and the chip (1).

3. Method according to either of the preceding claims, wherein the wire (7a, 7b) is kept taught opposite the groove (2a, 2b) and wherein the installation step consists in clamping the wire (7a, 7b) against the pad (6a, 6b).

4. Insertion method according to any of the preceding claims, wherein the pad (6a, 6b) is brought to the treatment temperature by exposing the region to a flow of hot air or to a luminous flux or, when said pad is made of metal, by induction.

5. Insertion method according to any of the preceding claims, comprising, before or during the installation step, a step of preparing the longitudinal portion of wire intended to be inserted into the groove (2a, 2b).

6. Insertion method according to the preceding claim, wherein the preparation step comprises depositing a coating layer on the longitudinal portion of the wire.

7. Insertion method according to either of the two preceding claims, wherein the preparation step comprises a step of cleaning and/or deoxidizing the longitudinal portion of the wire.

8. Insertion method according to any of the preceding claims, wherein the insertion step is followed by a reinforcement step comprising dispensing an adhesive into the groove (2a, 2b) and onto the longitudinal portion of the wire (7a, 7b), which portion is exposed in the groove (2a, 2b).

9. Insertion method according to any of the preceding claims, wherein the insertion step is followed by a step of encapsulating the chip (1) and/or the wires (7a, 7b).

10. Insertion method according to any of the preceding claims, wherein the wire (7a, 7b) is electrically conductive.

11. Insertion method according to any of the preceding claims, comprising repeating the installation and insertion steps so as to insert a plurality of chips (1) on the wire (7a, 7b) and form a chain (16, 21).

12. Apparatus (8) for inserting a wire (7a, 7b) into at least one chip (1), the chip having a groove (2a, 2b) for receiving a longitudinal portion of the wire and the groove (2a, 2b) containing a pad (6a, 6b) made of a bonding material having a predetermined melting point, the pad (6a, 6b) occupying a sufficient portion of the groove (2a, 2b) so as to not allow the wire to be fully accommodated therein, the apparatus comprising:
- placement members (9a, 9b, 9) which are capable of deploying and moving a length of the wire (7a, 7b) between a first and a second end of a workspace;
- a device (11) for handling the chip (1), which device is capable of arranging the chip in an insertion position in which the groove (2a, 2b) is placed opposite the wire (7a, 7b);
- an installation member (12) which is capable of arranging the longitudinal portion of the wire (7a, 7b) along the groove (2a, 2b), in forced abutment against the pad (6a, 6b);
- a heating member (13) which is capable of bringing a region comprising the pad (6a, 6b) to a treatment temperature which exceeds the predetermined melting point when the chip (1) is placed in the insertion position, thus causing the wire (7a, 7b) to be inserted into the groove (2a, 2b).

13. Insertion apparatus (8) according to the preceding claim, wherein the placement members (9a, 9b, 9) are configured to deploy two parallel wires between the first and the second end, and wherein the insertion position is located between the two wires.

14. Insertion apparatus (8) according to either of the two preceding claims, comprising at least one additional member (14) which is arranged in the workspace, downstream or upstream of the insertion position of the chip (1).

15. Insertion apparatus (8) according to any of the three preceding claims, wherein the additional member (14) and the installation member (12) are positioned and configured in the workspace so that the treatments carried out by these members can be conducted simultaneously.
